# NEUE EUROPÄISCHE PATENTSCHRIFT

(11) **EP 3 017 079 B2**
(45) Veröffentlichungstag und Bekanntmachung des Hinweises auf die Entscheidung über den Einspruch: **09.09.2020**
(45) Hinweis auf die Patenterteilung: 12.04.2017
(21) Anmeldenummer: 14737148.8
(22) Anmeldetag: 01.07.2014
(51) Int. Cl.: C23C 14/06, C23C 14/02, C23C 14/35, C23C 14/34

(54) **VERFAHREN ZUR HERSTELLUNG VON TIXSI1-XN SCHICHTEN**
PROCESS FOR THE PRODUCTION TIXSI1-XN LAYERS
PROCÉDÉ DE PRODUCTION DE COUCHES DE TIXSI1-XN

(30) Priorität: 03.07.2013 DE 102013011073; 03.07.2013 DE 102013011071
(43) Veröffentlichungstag der Anmeldung: 11.05.2016
(73) Patentinhaber: Oerlikon Surface Solutions AG, Pfäffikon, 8808 Pfäffikon SZ (CH)
(72) Erfinder: KURAPOV, Denis, CH-8880 Walenstadt (CH); KRASSNITZER, Siegfried, A-6800 Feldkirch (AT)
(74) Vertreter: Misselhorn, Hein-Martin
(86) Internationale Anmeldenummer: PCT/EP2014/001792
(87) Internationale Veröffentlichungsnummer: WO 2015/000581

(56) Entgegenhaltungen:
- EP-A1- 2 336 382
- EP-A2- 1 174 528
- EP-A2- 2 072 637
- WO-A1-2007/129021
- WO-A1-2011/149580
- WO-A1-2012/143087
- WO-A1-2012/143110
- WO-A1-2013/060415
- DE-A1-102011 117 177
- DE-A1-102011 117 177
- DE-B3-102012 209 293
- US-A1- 2006 147 728
- US-A1- 2006 147 728
- VAZ F ET AL: "Structural analysis of Ti1-xSixNy nanocomposite films prepared by reactive magnetron sputtering", SURFACE AND COATINGS TECHNOLOGY, ELSEVIER, AMSTERDAM, NL, Bd. 120-121, 1. November 1999 (1999-11-01) , Seiten 166-172, XP027328886, ISSN: 0257-8972 [gefunden am 1999-11-01]
- M NOSE ET AL: "Influence of sputtering conditions on the structure and properties of Ti-Si-N thin films prepared by r.f.-reactive sputtering", SURFACE AND COATINGS TECHNOLOGY, Bd. 174, Nr. 175, 1. Januar 2003 (2003-01-01), Seiten 261-265, XP055139815, DOI: 10.1016/S0257-8972Z03.00710-2
- D.V SHTANSKY ET AL: "Comparative investigation of Ti-Si-N films magnetron sputtered using Ti5Si3+Ti and Ti5Si3+TiN targets", SURFACE AND COATINGS TECHNOLOGY, Bd. 182, Nr. 2-3, 1. April 2004 (2004-04-01), Seiten 204-214, XP055139835, ISSN: 0257-8972, DOI: 10.1016/j.surfcoat.2003.08.052
- Shtansky D.V. et al: "Comparative investigation of Ti Si N films magnetron sputtered using Ti5Si3+Ti and Ti5Si3+TiN targets", Surface and Coatings Technology, vol. 182, no. 2-3, 22 April 2004 (2004-04-22), pages 204-214, DOI: 10.1016/j.surfcoat.2003.08.052
- Bobzin K. et al: "Properties of (Ti,Al,Si)N Coatings for High Demanding Metal Cutting Applications Deposited by HPPMS in an Industrial Coating Unit", Plasma Process. Polym., vol. 6, 1 January 2009 (2009-01-01), pages S124-S128, DOI: 10.1002/ppap.200930408
- Ehiasarian A.P.: "High-power impulse magnetron sputtering and its applications", Pure Appl. Chem., vol. 82, no. 6, 1 January 2010 (2010-01-01), pages 1247-1258, DOI: 10.1351/PAC-CON-09-10-43
- Ehiasarian A.P. et al: "Influence of high power impulse magnetron sputtering plasma ionization on the microstructure of TiN thin films", Journal of Applied Physics, vol. 109, 1 January 2011 (2011-01-01), pages 104314-1-104314-15, DOI: 10.1063/1.3579443
- Wikipedia Article on High-power impulse Magnetron sputtering (revision of page edited 20-02-2013)
- VAZ F ET AL: "Structural analysis of Ti1-xSixNy nanocomposite films prepared by reactive magnetron sputtering", SURFACE AND COATINGS TECHNOLOGY, ELSEVIER, AMSTERDAM, NL, vol. 120-121, 1 November 1999 (1999-11-01), pages 166 - 172, ISSN: 0257-8972, [retrieved on 19991101]
- Bobzin K. et al: "Advantages of nanocomposite coatings deposited by high power pulse magnetron sputtering technology", Journal of Materials Processing Technology, vol. 209, no. 1, 1 January 2009 (2009-01-01), pages 165-170, DOI: 10.1016/j.jmatprotec.2008.01.035

## Beschreibung

Die vorliegende Erfindung bezieht sich auf ein Beschichtungsverfahren.

Silizium ist ein chemisches Element welches im Zusammenhang mit Hartstoffschichten manchmal dazu eingesetzt wird die Schichtspannungen zu erhöhen. Erhöht sich die Schichtspannung so führt dies in der Regel zu einer grösseren Härte der Schicht. Dies kommt beispielsweise auch in Verbindung mit Titannitrid zum Einsatz. Daraus resultieren Schichten welche chemisch durch die Strukturformel TiₓSi₁₋ₓN beschrieben werden können, wobei x die in at% ausgedrückte Konzentration von Ti wenn nur die metallischen Elemente in Betracht gezogen werden ist. Bei dieser Schreibweise addieren sich die in Prozent angegebenen atomaren Konzentrationen zu 100%.

Solche Schichten lassen sich in sehr harter Form mittels des sogenannten kathodischen Funkenverdampfens herstellen. Dabei wird zwischen einem die metallischen Elemente liefernden Target, welches als Kathode eingesetzt wird und einer Anode ein Funken gezündet über den aus der Targetoberfläche ein Elektronenstrom hoher Dichte herausgezogen wird. Aufgrund der stark lokalisierten sehr hohen Stromdichte an der Targetoberfläche wird lokal die Targetoberfläche stark erhitzt und das Material in ionisierter Form verdampft.

Das derart verdampfte und ionisierte Material wird dann mit Hilfe einer an die Substrate angelegten negativen Spannung auf die Substrate zu beschleunigt. Wird zusätzlich die Beschichtungskammer ein Reaktivgas eingelassen so verbinden sich die verdampften Ionen mit dem Reaktivgas und bilden eine entsprechende Schicht auf der Substratoberfläche.

Bei diesem Verfahren kommt es jedoch häufig zu der sogenannten Droplet-Problematik: Aufgrund der plötzlichen lokalen Erhitzung auf der Targetoberfläche kommt es zu einer explosionsartigen Aufschmelzung dieser durch die ganze Tropfen des Targetmaterials in die Umgebung geschleudert werden. Diese Tropfen landen teilweise auf der Substratoberfläche was in der Regel negative Auswirkungen auf die Schichteigenschaften und deren Qualität nach sich zieht. Zwar gibt es inzwischen Methoden, diese Droplets herauszufiltern. Solche Filter lassen die Beschichtungsrate allerdings sehr klein werden und es ist kaum mehr möglich die Beschichtung wirtschaftlich zu betreiben.

Andererseits führt ein Siliziumanteil von grösser als 15at% sehr häufig während des Funkenverdampfens zur Beschädigung des Targets. Im Extremfall muss dann das Target nach jeder Beschichtung ausgewechselt werden, was wiederum der Wirtschaftlichkeit des Prozesses abträglich ist.

Diesen Problemen sieht sich der Fachmann beim konventionellen Abscheiden aus der Gasphase mittels Zerstäuben mit Magnetronunterstützung (Magnetron Sputtern) nicht ausgesetzt. Allerdings sind die von der Targetoberfläche durch Ionenbeschuss herausgeschlagenen Partikel nicht oder kaum ionisiert und lassen sich daher auch nicht mit einem an die Substrate angelegten Substratbias zu den Substraten beschleunigen. Entsprechend weissen solche auf konventionelle Art gesputterten Schichten eine relativ geringe Dichte und Härte auf.

Shtansky et al. zeigt in Surface and Coatings Technology 182 (2004) 204-214 ein Sputterverfahren zur Herstellung von Ti-Si-N Schichten. Eine bekannte Möglichkeit, die Dichte und Härte von Sputterschichten in dem Funkenverdampfen ähnliche Bereiche zu schieben ist das sogenannte HiPIMS Verfahren. HiPIMS = High Power Impulse Magnetron Sputtering). Bei diesem Sputterverfahren wird eine Sputterkathode mit hohen Leistungspulsdichten beaufschlagt, was dazu führt, dass das von der Kathode zerstäubte Material zu einem hohen Prozentsatz ionisiert ist. Wird nun eine negative Spannung an die zu beschichtenden Werkstücke angelegt, so werden diese Ionen in Richtung Werkstücke beschleunigt, was zu sehr dichten Schichten führt.

Die Sputterkathode muss pulsweise mit Leistung beaufschlagt werden, um ihr Zeit zu geben, den mit der Leistung einhergehenden Wärmeeintrag abzuführen. Beim HiPIMS Verfahren wird als Leistungsquelle daher ein Pulsgenerator benötigt. Dieser Pulsgenerator muss in der Lage sein sehr hohe Leistungspulse abzugeben, die jedoch sehr kurz sind. Die heute erhältlichen Pulsgeneratoren zeigen wenig Flexibilität, was zum Beispiel Pulshöhe und/oder Pulsdauer betrifft. Idealerweise sollte ein Rechteckpuls abgegeben werden. Zumeist ist jedoch die Leistungsabgabe innerhalb eines Pulses stark zeitabhängig, was unmittelbar Einfluss auf die Schichteigenschaften, wie zum Beispiel Härte, Haftung, Eigenspannung etc. hat. Ausserdem wird die Beschichtungsrate durch die Abweichung vom Rechteckprofil negativ beeinflusst.

Insbesondere werfen diese Schwierigkeiten Fragen hinsichtlich der Reproduzierbarkeit auf.

Soviel die Erfinder wissen wurde dementsprechend auch noch nicht versucht, TiₓSi₁₋ₓN Schichten mittels des HiPIMS Verfahrens herzustellen.

Es besteht daher ein Bedürfnis nach einem Verfahren, demgemäss TiₓSi₁₋ₓN Schichten mittels Magnetronzerstäuben bei hoher Leistung hergestellt werden können.

Erfindungsgemäss werden die Schichten mittels eines Sputterverfahrens hergestellt bei dem es zur konstant hohen Leistungsabgabe der Leistungsquelle kommt. Dabei kommen mehrere Sputterkathoden zum Einsatz. Anders als bei den konventionellen HiPIMS Verfahren wird kein Pulsgenerator eingesetzt sondern es wird zunächst lediglich eine erste Sputterkathode mit der vollen Leistung der Leistungsquelle und damit mit hoher Leistungsdichte beaufschlagt. Anschliessend wird eine zweite Sputterkathode mit den Ausgängen der Leistungsquelle verbunden. Dabei passiert zunächst wenig da die Impedanz der zweiten Sputterkathode zu diesem Zeitpunkt weitaus höher ist als die Impedanz der ersten Sputterkathode. Erst wenn die erste Sputterkathode von den Ausgängen der Leistungsquelle getrennt wird erfolgt die Leistungsabgabe im Wesentlichen über die zweite Sputterkathode. Das entsprechende Hochleistungsmagnetron-Sputterverfahren ist genauer in der WO 2013060415 beschrieben. Typischerweise wird die Leistungsquelle dabei in der Grössenordnung von 60kW gefahren. Typische Leistungen welchen die Sputterkathoden im zeitlichen Mittel ausgesetzt sind liegen grössenordnungsmässig bei 8kW.

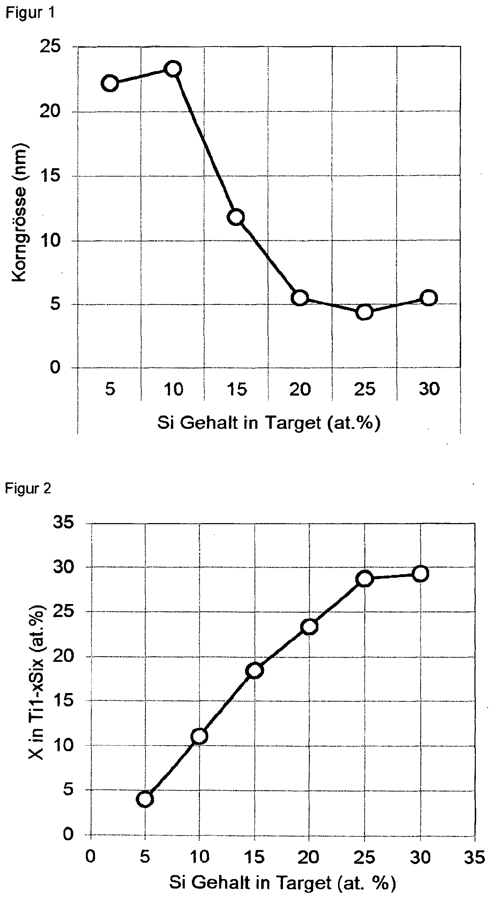

Die Erfinder haben nun völlig überraschend herausgefunden, dass wenn ein solches Verfahren mit TiSi-Targets betrieben wird, welche einen Siliziumanteil von grösser gleich 15at% enthalten es gelingt, reproduzierbar nanokristalline Schichten mit sehr guten mechanischen Eigenschaften zu erzeugen. Besonders interessant ist, dass ab einer Si-Konzentration im Target von 15at% die Nanokristalle im Mittel eine Korngrösse von weniger als 15nm aufweisen, wie in Figur 1 dargestellt. Dass sich die Konzentrationsverhältnisse im für die Beschichtung verwendeten Target nahezu direkt in der beschichteten Schicht wiederspiegeln ist in Figur 2 dargestellt. Es sei an dieser Stelle angemerkt dass, sobald ein Target mit einer gewissen Si-Konzentration gewählt wurde, sich die Korngrösse über den Stickstoffverbrauch feineinstellen lässt, wie Figur 7 zeigt.

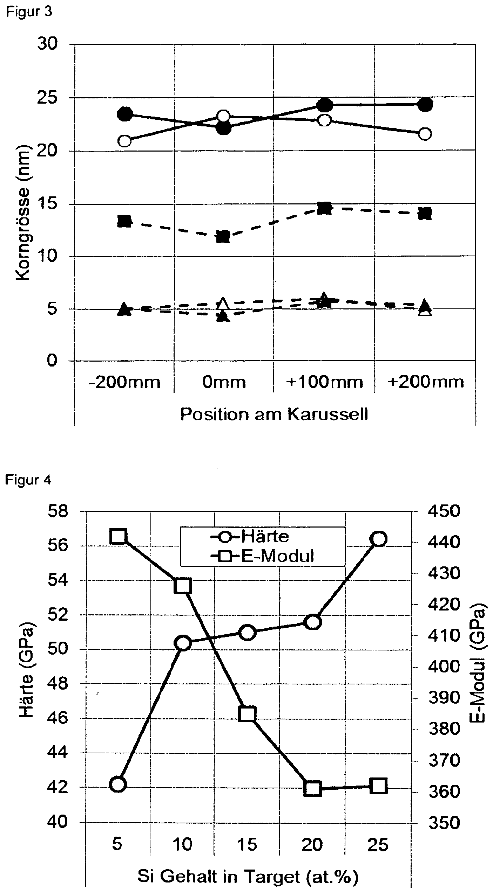

Dass es sich hierbei um ein sehr robustes Phänomen handelt ist an Figur 3 ersichtlich. Hier wurden die Korngrössen von Schichten vermessen, welche an unterschiedlichen Positionen auf dem rotierenden Karussell beschichtet wurden. Die Messreihe mit den schwarz gefüllten kreisrunden Symbolen bezieht sich auf ein Ti₉₅Si₅ -Target. Die Messreihe mit den weiss gefüllten kreisrunden Symbolen bezieht sich auf ein Ti₉₀Si₁₀ -Target. Die Messreihe mit den schwarz gefüllten quadratischen Symbolen bezieht sich auf ein Ti₈₅Si₁₅ -Target. Die Messreihe mit den weiss gefüllten dreieckigen Symbolen bezieht sich auf ein Ti₈₀Si₂₀-Target. Die Messreihe mit den schwarz gefüllten dreieckigen Symbolen bezieht sich auf ein Ti₇₅Si₁₅ -Target. Offensichtlich wird die Korngrösse jeweils über die gesamte Beschichtungshöhe der Kammer eingehalten.

Die Schichten weisen dann mit zunehmendem Siliziumgehalt eine zunehmende Härte und ein abnehmendes E-Modul auf, wie in Figur 4 dargestellt. Dort sind nicht die Konzentrationsverhältnisse in den Schichten sondern die Konzentrationsverhältnisse Ti/Si in den für die Herstellung der Schichten verwendeten Targets angegeben.

Gemäss einer weiteren Ausführungsform der vorliegenden Erfindung wird die TiₓSi₁₋ₓN - Schicht mit mindestens 15at%-tigem Si Anteil der metallischen Komponenten nicht direkt auf das zu beschichtende Substrat aufgebracht sondern zwischen Substrat und der erfindungsgemässen Schicht eine TiAlN-Schicht als Zwischenschicht vorgesehen. Diese Zwischenschicht hat u.a. den Vorteil, dass sie zwischen dem weniger spröden Substrat und der äusserst harten und mit sehr hohen Eigenspannungen belasteten TiₓSi₁₋ₓN - Schicht hinsichtlich den Spannungs- und/oder Druckverhältnissen vermittelt. Hierdurch kommt es viel weniger zu Abplatzungen und die Schichthaftung ist entsprechend verbessert.

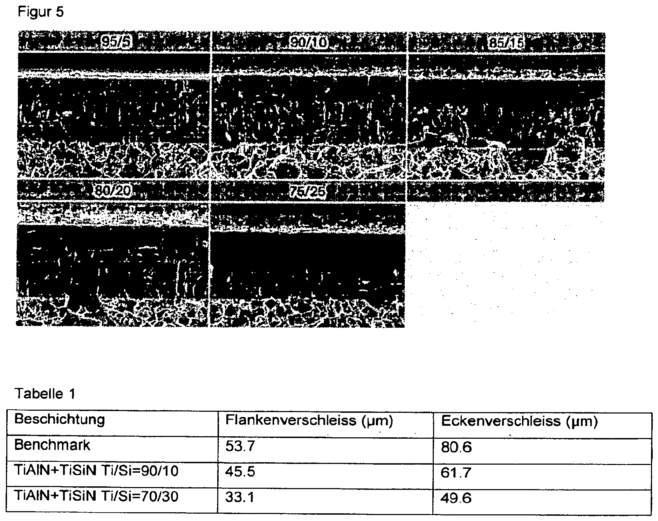

Figur 5 zeigt eine Serie solcher erfindungsgemässer Zweischichter, wobei für die Beschichtung der TiₓSi₁₋ₓ- Schichten wiederum die bereits besprochenen unterschiedlichen Targets gemäss den Angaben in der Figur verwendet wurden. Deutlich sichtbar in der Serie sind die unterschiedlichen Strukturen der TiₓSi₁₋ₓ- Schichten, die steigendem Si-Gehalt immer feiner werden. Im vorliegenden Beispiel wurde zur Herstellung der Zwischenschicht ein Target verwendet, welches 40at% Titan und 60at% Aluminium umfasst. Es wurde festgestellt, dass besonders Vorteilhaft ist wenn beide Schichten TiAlN und TiSiN eine (200) Textur aufweisen.

Es wurden solche Doppelschichten mit unterschiedlichem Si-Gehalt an Werkzeugen getestet. Die Zerspanungstests wurden unter folgenden Bedingungen durchgeführt: Werkstück Stahl DIN 1.2344 gehärtet auf 45HRC, Werkzeug Durchmesser 10mm Vollhartmetallfräser, Schnittgeschwindigkeit 220m/min, Vorschub pro Zahn 0.1mm, axiale Zustellung 10mm, radiale Zustellung 0.5mm. Dabei wurde gemessen durch wieviele Meter sich ein entsprechendes Werkzeug arbeiten kann, ohne Schaden zu nehmen. Werkzeug welches mit einer marktüblichen Schicht beschichtet ist, überlebt für etwas mehr als 200m. In etwa gleich lang überlebt Werkzeug, welches mit der oben beschriebenen Doppelschicht beschichtet ist, wobei die äussere Schicht lediglich 5% Silizium enthält. Demgegenüber zeigten die Tests dass das Werkzeug mehr als 500m überlebt wenn die äussere Schicht zumindest 15% Silizium enthält. In der Tabelle 1 sind die Verschleisswerte gemessen bei den Werkzeugen nach 140m Schneidweg aufgelistet. Man erkennt eindeutig, dass Verschleiss bei der Beschichtung mit 30% Silizium am geringstem ist.

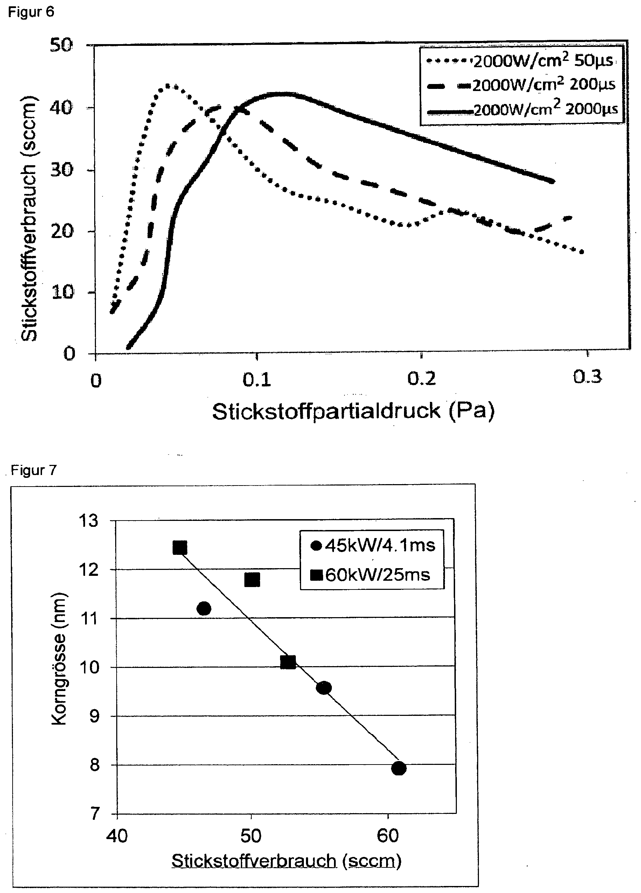

Gemäss einer weiteren, vorteilhaften Ausführungsform wird zwischen der TiAlN-Zwischenschicht und der TiₓSi₁₋ₓ-Schicht eine Übergangsschicht vorgesehen, die mittels Cosputtern hergestellt wurde. Mit dem oben beschriebenen Sputterverfahren lässt sich Cosputtern in zuverlässiger Weise so durchführen, dass beispielsweise die Pulslängen für die unterschiedlichen Targets so gewählt werden, dass die Maxima der Reaktivgasverbrauchkurven in Abhängigkeit vom in der Beschichtungskammer vorherrschenden Druck im Wesentlichen übereinander zu liegen kommen. Dies ist deswegen möglich, weil die Pulsdauer direkt Einfluss auf die Lage der entsprechenden Maxima hat. Dies ist für ein Beispiel in Figur 6 dargestellt, wo mit 3 unterschiedlichen Pulsdauern (0.05ms, 0.2ms und 2ms) gesputtert wurde auf diese Weise ist es möglich beide Targets bei denselben in der Kammer vorherrschenden Druck und Gasflussverhältnissen optimal zu betreiben.

Gemäss einer weiteren Ausführungsform der vorliegenden Erfindung wird die Übergangsschicht als Gradientenschicht verwirklicht, welche mit zunehmendem Abstand von der Substratoberfläche einen abnehmenden Anteil an TiAlN und einen zunehmenden Anteil an TiₓSi₁₋ₓN besitzt.

Gemäss einer weiteren Ausführungsform der vorliegenden Erfindung ist die abschliessende TiₓSi₁₋ₓN -Schicht keine reine TiₓSi₁₋ₓN- Schicht sondern enthält noch Anteile an TiAlN.

Gemäss einer weiteren Ausführungsform der vorliegenden Erfindung wird für die Beschichtung ein erstes TiₓSi₁₋ₓ- Target und ein zweites Ti_{z}Si_{1-z} Target verwendet, wobei 0≤x≤1 und 0≤z≤1 sein kann, aber z≠x ist, d.h. erstes und zweites Target sich in ihrer Zusammensetzung unterscheiden und (x+z)/2 ≤0.85 ist, so dass sich weiterhin Schichten mit einer Si-Konzentration von ≥15at% herstellen lassen. Im Verfahren können dann beide Targets nach der oben beschriebenen Co-sputter-Methodik betrieben werden. Dies gestattet während der Beschichtung die Si-Konzentration zu variieren, d.h. einen Si-Konzentrationsverlauf zu realisieren.

Ferner haben die Erfinder festgestellt, dass überraschend hervorragende Schichtperformances von erfindungsgemäss abgeschiedenen Schichten sich durch die Verwendung einer Cr_{y}Al_{1-y}N-Schicht als Zwischenschicht erreichen lassen. Demgemäss werden nachstehend weitere, bevorzugte Ausführungsformen der vorliegenden Erfindung beschrieben, welche Cr_{y}Al_{1-y}N-Schichten als Zwischenschichten umfassen.

Gemäss einer weiteren Ausführungsform der vorliegenden Erfindung wird die TiₓSi₁₋ₓN - Schicht mit mindestens 15at%-tigem Si Anteil der metallischen Komponenten nicht direkt auf das zu beschichtende Substrat aufgebracht sondern zwischen Substrat und der erfindungsgemässen Schicht eine Cr_{y}Al_{1-y}N-Schicht als Zwischenschicht vorgesehen. Dabei hat sich ein Chromanteil von 40at% und ein Aluminiumanteil von 60at% als vorteilhaft herausgestellt. Diese Zwischenschicht hat u.a. den Vorteil, dass sie zwischen dem weniger spröden Substrat und der äusserst harten und mit sehr hohen Eigenspannungen belasteten TiₓSi₁₋ₓN - Schicht hinsichtlich den Spannungs- und/oder Druckverhältnissen vermittelt. Hierdurch kommt es viel weniger zu Abplatzungen und die Schichthaftung ist entsprechend verbessert.

Im vorigen Abschnitt und in der folgenden Beschreibung gibt x die in at% ausgedrückte Konzentration von Ti und y die in at% ausgedrückte Konzentration an Cr angibt, wenn nur die metallischen Elemente in Betracht gezogen werden.

Es wurden solche Doppelschichten mit unterschiedlichem Si-Gehalt an Werkzeugen getestet. Dabei wurde gemessen durch wieviele Meter sich ein entsprechendes Werkzeug arbeiten kann, ohne signifikanten Schaden zu nehmen. Die Zerspanungstests wurden unter folgenden Bedingungen durchgeführt: Werkstück Stahl DIN 1.2379 gehärtet auf 69HRC, Werkzeug Durchmesser 2mm Vollhartmetallkugelkopffräser, Schnittgeschwindigkeit 110m/min, Vorschub pro Zahn 0.04mm, axiale Zustellung 0.1mm, radiale Zustellung 0.04mm. Werkzeug welches mit einer marktüblichen Schicht beschichtet ist, überlebt für etwas mehr als 60m. Demgegenüber überlebt Werkzeug, welches mit der oben beschriebenen Doppelschicht beschichtet ist, wobei die äussere Schicht mindestens 10% Silizium enthält, für mehr als 100m. Interessant dabei ist dass die CrAlN-Schicht relativ dünn gehalten werden sollte. Dies deutet darauf hin, dass die CrAlN Schicht im Wesentlichen die Funktion einer Haftschicht übernimmt.

Gemäss einer weiteren, vorteilhaften Ausführungsform wird zwischen der CrAlN-Zwischenschicht und der TiₓSi₁₋ₓ-Schicht eine Übergangsschicht vorgesehen, die mittels Cosputtern hergestellt wurde. Mit dem oben beschriebenen Sputterverfahren lässt sich Cosputtern in zuverlässiger Weise so durchführen, dass beispielsweise die Pulslängen für die unterschiedlichen Targets so gewählt werden, dass die Maxima der Reaktivgasverbrauchkurven in Abhängigkeit vom in der Beschichtungskammer vorherrschenden Druck im Wesentlichen übereinander zu liegen kommen. Dies ist deswegen möglich, weil die Pulsdauer direkt Einfluss auf die Lage der entsprechenden Maxima hat. Dies ist für ein Beispiel in Figur 6 dargestellt, wo mit 3 unterschiedlichen Pulsdauern (0.05ms, 0.2ms und 2ms) gesputtert wurde. Auf diese Weise ist es möglich beide Targets bei denselben in der Kammer vorherrschenden Druck und Gasflussverhältnissen optimal zu betreiben.

Gemäss einer weiteren Ausführungsform der vorliegenden Erfindung wird die Übergangsschicht als Gradientenschicht verwirklicht, welche mit zunehmendem Abstand von der Substratoberfläche einen abnehmenden Anteil an CrAlN und einen zunehmenden Anteil an TiₓSi₁₋ₓN besitzt.

Gemäss einer weiteren Ausführungsform der vorliegenden Erfindung ist die abschliessende TiₓSi₁₋ₓN -Schicht keine reine TiₓSi₁₋ₓN- Schicht sondern enthält noch Anteile an CrAlN.

Die Erfindung betrifft konkret dann ein Verfahren gemäß Anspruch 1 zur Beschichtung eines Werkstücks mit einer Beschichtung, wobei Beschichtung zumindest
eine TixSi1-xN Schicht umfasst, dadurch gekennzeichnet,
dass x<= 0.85 und die TixSi1-xN Schicht Nanokristalle
enthält und die enthaltenen Nanokristalle eine durchschnittliche Korngrösse von nicht mehr als 15nm besitzen
und vorzugsweise eine (200) Textur aufweist. Die
Erfindung betrifft ausserdem ein Verfahren gemäß Anspruch 1 zur Beschichtung
eines Werkstücks mit einer Beschichtung, die zumindest
die vorgenannte TiₓSi₁₋ₓN Schicht umfasst, wobei
das für die Herstellung der TiₓSi₁₋ₓN Schicht eingesetzte Verfahren ein Sputterverfahren ist, bei dem mindestens ein TiₓSi₁₋ₓ -Target als Sputtertarget verwendet
wird, wobei x <= 0.85 in Atom-%, und wobei es auf der Targetoberfläche des Sputtertargets zu Stromdichten von mindestens 0.2 A/cm², vorzugsweise grösser 0.2 A/cm² kommt. Vorzugsweise ist zwischen der TiₓSi₁₋ₓN Schicht und dem Substratkörper des Werkstücks eine Zwischenschicht vorgesehen, welche TiAlN oder CrAlN oder TiAlN und CrAlN umfasst.

Gemäss einer bevorzugten Ausführungsform eines Verfahrens zur Beschichtung eines Werkstücks gemäss der anspruchs gemäßen Erfindung, bei dem eine Übergangsschicht
abgeschieden werden sollte, wird die Übergangsschicht mittels Co-Sputtern hergestellt.

Wenn es für bestimmte Anwendungen Vorteile bringt, kann die mit dem erfindungsgemäßen Beschichtungsverfahren erhaltene TiₓSi₁₋ₓN Schicht gemäss der vorliegenden
Erfindung noch Anteile an TiAlN oder CrAlN oder TiAlN und CrAlN enthalten.

Je nach Anwendung kann auch möglich sein, dass in den oben genannten Ausführungsformen der vorliegenden Erfindung statt TiAlN oder CrAlN in der Beschichtung andere Metallnitride oder Metallnitrid-basierte Materialien verwendet werden, um gewünschte Schichteigenschaften zu erreichen.

## Patentansprüche

1. Verfahren zur Beschichtung eines Werkstücks mit einer Beschichtung, die zumindest eine TiₓSi₁₋ₓN Schicht umfasst, bei der x ≤ 0.85 ist und wobei die TiₓSi₁₋ₓN Schicht Nanokristalle enthält und die enthaltenen Nanokristalle eine durchschnittliche Korngrösse von nicht mehr als 15nm besitzen, wobei x die in at% ausgedrückte Konzentration von Ti ist, wenn nur die metallischen Elemente in Betracht gezogen werden, **dadurch gekennzeichnet dass** für die Herstellung der TiₓSi₁₋ₓN Schicht ein Sputterverfahren eingesetzt wird, bei dem mindestens ein TiₓSi₁₋ₓ -Target als Sputtertarget verwendet wird, wobei x ≤ 0.85 in Atom% ist, und wobei es auf der Targetoberfläche des Sputtertargets zu Stromdichten von mindestens 0.2 A/cm², vorzugsweise grösser 0.2 A/cm² kommt, dass zunächst eine erste Sputterkathode mit der vollen Leistung der Leistungsquelle und damit mit hoher Leistungsdichte beaufschlagt wird, dass anschliessend eine zweite Sputterkathode mit den Ausgängen der Leistungsquelle verbunden wird, wobei die Leistungsabgabe erst dann, wenn die erste Sputterkathode von den Ausgängen der Leistungsquelle getrennt wird, im Wesentlichen über die zweite Sputterkathode erfolgt und dass die Leistungsquelle konstant hohe Leistung abgibt.

2. Verfahren nach Anspruch 1, **dadurch gekennzeichnet, dass** das Verfahren zur Beschichtung eines Werkstücks eingesetzt wird bei dem zwischen der TiₓSi₁₋ₓN Schicht und dem Substratkörper des Werkstücks eine Zwischenschicht mit TiAIN vorgesehen ist.

3. Verfahren nach Anspruch 1, **dadurch gekennzeichnet, dass** das Verfahren zur Beschichtung eines Werkstücks eingesetzt wird, bei dem zwischen der Zwischenschicht und der TiₓSi₁₋ₓN Schicht eine Übergangsschicht vorgesehen ist, welche sowohl TiAIN als auch TiₓSi₁₋ₓN enthält.

4. Verfahren nach Anspruch 1, **dadurch gekennzeichnet, dass** das Verfahren zur Beschichtung eines Werkstücks eingesetzt wird, bei dem die Übergangsschicht eine Gradientenschicht ist, deren Siliziumanteil mit zunehmendem Abstand von der Substratoberfläche zunimmt.

5. Verfahren nach Anspruch 1, **dadurch gekennzeichnet, dass** das Verfahren zur Beschichtung eines Werkstücks eingesetzt wird, bei dem zwischen der TiₓSi₁₋ₓN Schicht und dem Substratkörper des Werkstücks eine Zwischenschicht mit Cr_{y}Al_{1-y}N vorgesehen ist, wobei y die in at% ausgedrückte Konzentration an Cr angibt, wenn nur die metallischen Elemente in Betracht gezogen werden.

6. Verfahren nach Anspruch 5, **dadurch gekennzeichnet, dass** das Verfahren zur Beschichtung eines Werkstücks eingesetzt wird, bei dem zwischen der Zwischenschicht und der TiₓSi₁₋ₓN Schicht eine Übergangsschicht vorgesehen ist, welche sowohl Cr_{y}Al_{1-y}N als auch TiₓSi₁₋ₓN enthält.

7. Verfahren nach Anspruch 6, **dadurch gekennzeichnet, dass** das Verfahren zur Beschichtung eines Werkstücks eingesetzt wird, bei dem die Übergangsschicht eine Gradientenschicht ist, deren Siliziumanteil mit zunehmendem Abstand von der Substratoberfläche zunimmt.

8. Verfahren zur Beschichtung eines Werkstücks nach einem der vorangehenden Ansprüche 3, 4, 6 oder 7, **dadurch gekennzeichnet, dass** die Übergangsschicht mittels Co-Sputtern hergestellt wird.

## Claims

1. A method for coating a workpiece with a coating comprising at least one TiₓSi₁₋ₓN layer, wherein x ≤ 0.85 and wherein the TiₓSi₁₋ₓN layer contains nanocrystals and the nanocrystals contained have an average grain size of not more than 15 nm, wherein x is the concentration of Ti expressed in at% when only the metallic elements are taken into account, **characterized in that** a sputtering process is used for the production of the TiₓSi₁₋ₓN layer, in which at least one TiₓSi₁₋ₓ target is used as a sputtering target, wherein x ≤ 0.85 in atom-% and wherein current densities of at least 0.2 A/cm², preferably more than 0.2 A/cm², occur on the target surface of the sputtering target, that the full power of the power source and thus a high power density is initially applied to a first sputtering cathode, that a second sputtering cathode is then connected to the outputs of the power source, wherein power is output substantially via the second sputtering cathode only when the first sputtering cathode is separated from the outputs of the power source, and that the power source constantly outputs high power.

2. The method according to claim 1, **characterized in that** the method is used for coating a workpiece in which an intermediate layer with TiAlN is provided between the TiₓSi₁₋ₓN layer and the substrate body of the workpiece.

3. The method according to claim 1, **characterized in that** the method is used for coating a workpiece in which a transition layer containing both TiAlN and TiₓSi₁₋ₓN is provided between the intermediate layer and the TiₓSi₁₋ₓN layer.

4. The method according to claim 1, **characterized in that** the method is used for coating a workpiece in which the transition layer is a gradient layer whose silicon content increases as the distance from the substrate surface increases.

5. The method according to claim 1, **characterized in that** the method is used for coating a workpiece in which an intermediate layer with Cr_{y}Al_{1-y}N is provided between the TiₓSi₁₋ₓN layer and the substrate body of the workpiece, wherein y indicates the Cr concentration expressed in at%, when only the metallic elements are taken into account.

6. The method according to claim 5, **characterized in that** the method is used for coating a workpiece in which a transition layer containing both Cr_{y}Al_{1-y}N and TiₓSi₁₋ₓN is provided between the intermediate layer and the TiₓSi₁₋ₓN layer.

7. The method according to claim 6, **characterized in that** the method is used for coating a workpiece in which the transition layer is a gradient layer whose silicon content increases as the distance from the substrate surface increases.

8. A method for coating a workpiece according to any one of the preceding claims 3, 4, 6 or 7, **characterized in that** the transition layer is produced by means of co-sputtering.

## Revendications

1. Procédé de revêtement d'une pièce par un revêtement qui comprend au moins une couche en TiₓSi₁₋ₓN, dans laquelle x ≤ 0,85 et dans laquelle la couche TiₓSi₁₋ₓN contient des nanocristaux et les nanocristaux contenus possèdent une granulométrie moyenne qui ne dépasse pas 15 nm, dans laquelle x est la concentration de Ti exprimée en pourcentage atomique lorsque l'on prend en compte seulement les éléments métalliques, **caractérisé en ce que** pour la réalisation de la couche en TiₓSi₁₋ₓN, on utilise un procédé de pulvérisation cathodique dans lequel on utilise à titre de cible de pulvérisation cathodique au moins une cible en TiₓSi₁₋ₓ, dans laquelle x ≤ 0,85 en pourcentage atomique, et dans laquelle des densités de courant d'au moins 0,2 A/cm², de préférence supérieures à 0,2 A/cm², s'établissent sur la surface de la cible de pulvérisation cathodique, **en ce que** d'abord une première cathode de pulvérisation cathodique est alimentée avec la pleine puissance de la source de puissance et donc avec une forte densité de puissance, **en ce qu'**ensuite une seconde cathode de pulvérisation cathodique est reliée aux sorties de la source de puissance, l'application de la puissance ayant lieu uniquement lorsque la première cathode de pulvérisation cathodique est séparée des sorties de la source de puissance, essentiellement via la seconde cathode de pulvérisation cathodique, et **en ce que** la source de puissance délivre une puissance constante élevée.

2. Procédé selon la revendication 1, **caractérisé en ce que** le procédé est utilisé pour revêtir une pièce dans laquelle est prévue une couche intermédiaire contenant du TiAlN entre la couche en TiₓSi₁₋ₓN et le corps du substrat de la pièce.

3. Procédé selon la revendication 1, **caractérisé en ce que** le procédé est utilisé pour revêtir une pièce dans laquelle est prévue une couche de transition entre la couche intermédiaire et la couche en TiₓSi₁₋ₓN qui contient aussi bien du TiAlN que du TiₓSi₁₋ₓN.

4. Procédé selon la revendication 1, **caractérisé en ce que** le procédé est utilisé pour revêtir une pièce dans laquelle la couche de transition est une couche à gradient dont la proportion de silicium augmente au fur et à mesure de l'augmentation de la distance vis-à-vis de la surface du substrat.

5. Procédé selon la revendication 1, **caractérisé en ce que** le procédé est utilisé pour revêtir une pièce dans laquelle est prévue une couche intermédiaire contenant du Cr_{y}Al_{1-y}N entre la couche en TiₓSi₁₋ₓN et le corps du substrat de la pièce, dans laquelle y indique la concentration en Cr exprimée en pourcentage atomique lorsque l'on prend en compte seulement les éléments métalliques.

6. Procédé selon la revendication 5, **caractérisé en ce que** le procédé est utilisé pour le revêtement d'une pièce dans laquelle est prévue une couche de transition entre la couche intermédiaire et la couche en TiₓSi₁₋ₓN, qui contient aussi bien du Cr_{y}Al_{1-y}N que du TiₓSi₁₋ₓN.

7. Procédé selon la revendication 6, **caractérisé en ce que** le procédé est utilisé pour le revêtement d'une pièce dans laquelle la couche de transition est une couche à gradient dont la proportion de silicium augmente au fur et à mesure de l'augmentation de la distance vis-à-vis de la surface du substrat.

8. Procédé de revêtement d'une pièce selon l'une des revendications précédentes 3, 4, 6 ou 7, **caractérisé en ce que** la couche de transition est réalisée par une pulvérisation cathodique de Co.
